(19) Europäisches Patentamt
European Patent Office
Office européen des brevets

(11) **EP 4 187 220 A1**

(12) **EUROPEAN PATENT APPLICATION**

(43) Date of publication:
**31.05.2023 Bulletin 2023/22**

(21) Application number: **22210158.6**

(22) Date of filing: **29.11.2022**

(51) International Patent Classification (IPC):
**G01K 1/024** (2021.01)     **B64C 25/42** (2006.01)
**F16D 55/00** (2006.01)     **G01K 11/26** (2006.01)
**G01K 13/08** (2006.01)     **F16D 66/00** (2006.01)

(52) Cooperative Patent Classification (CPC):
**G01K 11/265; B64C 25/42; F16D 55/00;
G01K 1/024; G01K 13/08;** F16D 2066/001

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.11.2021 US 202163284263 P**

(71) Applicants:
• **Airbus Operations Limited
Bristol BS34 7PA (GB)**
• **Airbus Opérations SAS
31060 Toulouse (FR)**

(72) Inventors:
• **DA CUNHA, Mauricio Pereira
Orono, 04473 (US)**
• **LAD, Robert J.
Orono, 04473 (US)**
• **WHITE, Ian
Bristol BS34 7PA (GB)**
• **BRUGGEMANN, Kurt
Bristol BS34 7PA (GB)**
• **DOWNING, Richard
Bristol BS34 7PA (GB)**
• **CONSOLA, Maud
Bristol BS34 7PA (GB)**

(74) Representative: **EIP
Fairfax House
15 Fulwood Place
London WC1V 6HU (GB)**

(54) **TEMPERATURE SENSING DEVICE AND METHOD FOR AIRCRAFT WHEEL BRAKE**

(57)     Disclosed is a temperature sensing device for sensing aircraft wheel brake temperature, the temperature sensing device comprising: a surface acoustic wave, SAW, sensor element with a resonant frequency within a frequency range between 175 megahertz and 190 megahertz at a predetermined temperature. Also disclosed in a temperature sensing system comprising the temperature sensing device and a wireless relay device, a method for sensing temperature of a wheel brake of an aircraft, and an aircraft comprising the temperature sensing system.

Figure 3

**Description**

TECHNICAL FIELD

The present invention relates to sensing aircraft wheel brake temperature.

BACKGROUND

When aircraft wheel brakes are deployed to reduce the speed of an aircraft, the temperature of the aircraft wheel brakes rises. It can be advantageous to monitor the temperature of the aircraft wheel brakes to, for example, ensure that the brakes do not overheat. For example, temperature sensors such as thermocouples can be used to sense temperature.

SUMMARY

A first aspect of the present invention provides a temperature sensing device for sensing aircraft wheel brake temperature, the temperature sensing device comprising: a surface acoustic wave, SAW, sensor element with a resonant frequency within a frequency range between 175 megahertz and 190 megahertz at a predetermined temperature.

Optionally, the resonant frequency is within the frequency range when the temperature of the SAW sensor element is within a predetermined temperature range.

Optionally, the predetermined temperature range is from 24°C to 1000°C.

Optionally, the frequency range is from 176 megahertz to 188 megahertz.

Optionally, the temperature sensing device according to the first aspect comprises: a sensor antenna configured to wirelessly receive an interrogation signal, and supply the interrogation signal to the SAW sensor element, wherein: the interrogation signal scans frequencies within the frequency range.

Optionally, the SAW sensor element is configured to, responsive to the interrogation signal, output a signal as a response, the output signal indicative of the resonant frequency of the SAW sensor element, to the antenna, and the sensor antenna is configured to wirelessly transmit the output signal.

According to a second aspect of the present invention, there is provided a temperature sensing system for sensing aircraft wheel brake temperature comprising the temperature sensing device according to the first aspect, and comprising: a wireless relay device for delivering an interrogation signal for wirelessly interrogating the SAW sensor element by wirelessly transmitting the interrogation signal to the temperature sensing device, wherein the interrogation signal scans frequencies within the frequency range.

According to a third aspect of the present invention, there is provided a method for sensing a temperature of a wheel brake of an aircraft, the method comprising: wirelessly transmitting an interrogation signal having a frequency within a frequency range between 175 megahertz and 190 megahertz to a surface acoustic wave, SAW, sensor element mounted to a brake disc of the wheel brake; and wirelessly receiving an output signal indicative of the temperature of the brake disc from the SAW sensor element.

Optionally, in the method according to the third aspect, the frequency range is between 176 megahertz and 188 megahertz.

Optionally, in the method according to the third aspect, the interrogation signal scans frequencies within the frequency range.

Optionally, in the method according to the third aspect, the output signal is indicative of the resonant frequency of the SAW sensor element; and the method comprises determining the temperature of the brake disc based on a predefined relationship between the resonant frequency and the temperature of the SAW sensor element.

According to a fourth aspect of the present invention, there is provided an aircraft comprising the temperature sensing system according to the second aspect.

BRIEF DESCRIPTION OF THE DRAWINGS

Embodiments of the invention will now be described, by way of example only, with reference to the accompanying drawings, in which:

Figure 1 is a simplified schematic view of an aircraft on which examples may be deployed;

Figure 2 is a simplified schematic view of a brake and a wheel of an aircraft landing gear assembly according to an example;

Figure 3 is a simplified schematic block diagram of a temperature sensing device according to a first example;

Figure 4 is a simplified schematic plan view of a surface acoustic wave sensor element, according to an example;

Figure 5 is a simplified schematic block diagram of a temperature sensing system according to an example; and

Figure 6 is a flow diagram of a method for sensing a temperature of a wheel brake of an aircraft, according to an example.

DETAILED DESCRIPTION

The following disclosure relates to a temperature sensing device for sensing aircraft wheel brake temperature.

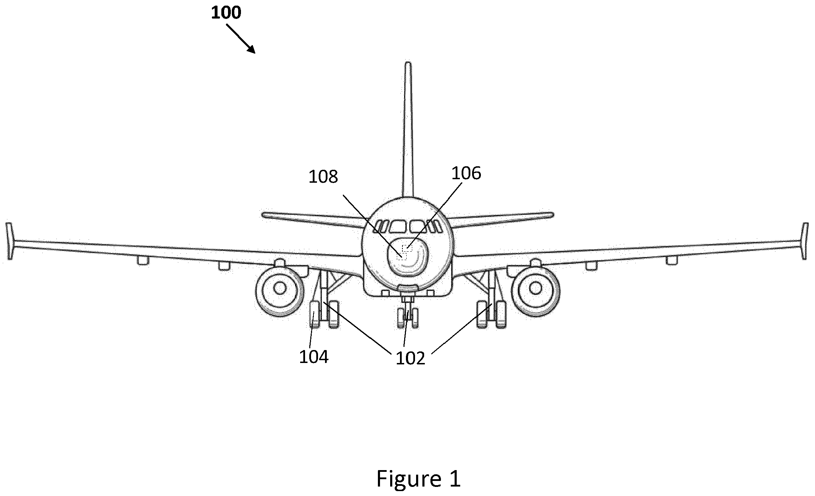

Figure 1 is a simplified schematic view of an aircraft 100. The aircraft 100 comprises a plurality of landing gear assemblies 102. The landing gear assemblies may include main and nose landing gears that are deployed or extended during take-off and landing. Each landing gear assembly 102 includes wheels 104. The aircraft 100 comprises a computing system 106, which, for example, comprises one or more processors and one or more computer readable storage media. The aircraft 100 may also comprise instruments 108, such as instruments or sensors for measuring characteristics or parameters related to the aircraft, and instruments or sensors for measuring environmental characteristics.

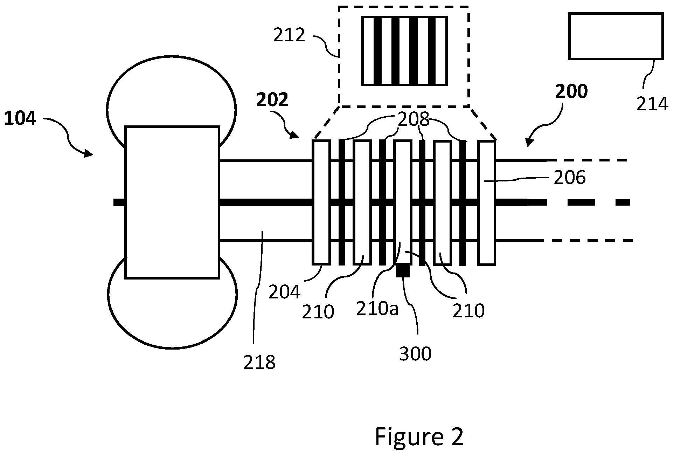

Figure 2 is a simplified schematic view of an aircraft wheel brake 200 associated with the wheel 104 of the aircraft 100. The wheel brake 200 applies a braking force to inhibit the rotation of the wheel 104 when applied. Each of the wheels of the aircraft 100 may have a wheel brake 200 associated with it. In this example, the wheel brake 200 comprises a plurality of brake discs 202 including a pressure plate 204, a reaction plate 206, and a number of rotors 208 and stators 210. In this example, the brake discs 202 include a plurality of rotors and stators, and the wheel brake 200 is therefore a multiple disc brake. In other examples, the wheel brake 200 may not be a multiple-disc brake: there may be only one disc 208, for example, between a pressure plate 204 and a reaction plate 206. In some examples, the brake discs 202 may include up to 9 discs or 11 discs, or any other number which is suitable for a wheel brake of an aircraft. The brake discs 202 may collectively be referred to as a heat pack. The components of the wheel brake 200 (hereafter, for brevity, the wheel brake 200 is referred to simply as the brake 200) such as the brake discs 202 may be housed in a wheel brake housing (not shown). As referred to herein, the term brake is used as if to include such a wheel brake housing.

It will be understood that the type of wheel brake used in an aircraft landing gear depends on the characteristics of the aircraft in question, such as size, carrying capacity and the like. The following may be applied to any wheel brakes suitable for use as aircraft wheel brakes which heat up when applied to reduce aircraft speed, as discussed in the following.

When the aircraft 100 travels along the ground supported by the landing gear assembly 102, the rotors rotate with the wheel 104 (the rotors are keyed to the wheel 104), whereas the stators, the pressure plate 204 and the reaction plate 206 do not rotate with the wheel 104 (the stators, the pressure plate 204 and the reaction plate 206 are keyed to a torque tube 218 associated with the wheel 104 which does not rotate with the wheel 104). When braking is applied, the pressure plate 204 is urged towards the reaction plate 206 so that the brake discs 202 come into contact with one another (as shown in box 212 of Figure 2) and friction acts to inhibit the rotational motion of the rotors, thus generating a braking force. When the brake 200 is applied, some of the kinetic energy of the aircraft 100 is absorbed into the brake discs 202 as heat (by the action of friction). Accordingly, the brake 200 heats up when it is applied to cause the aircraft 100 to slow down.

Any one or more of the rotors, stators, pressure plate 204 and the reaction plate 206 may be composed of Carbon-Carbon (CC) composites. A brake including brake discs composed of CC composites may be referred to as a carbon brake. For example, the brake discs 202 may be composed of a graphite matrix reinforced by carbon fibers.

In this example, the aircraft 100 comprises a braking system 214 which controls the operation of the brake 200. The braking system 214 causes the brake 200 to be applied in response to a braking request (e.g. when a pilot of the aircraft 100 presses a brake pedal). For example, the brake 200 may be hydraulically actuated in which case the braking system 214 includes a hydraulic system (not shown) operationally connected with the brake 200. In other examples, the brake 200 may be electrically actuated in which case the braking system 214 includes an electronic brake actuation system. The braking system 214 may be controlled by the computing system 106.

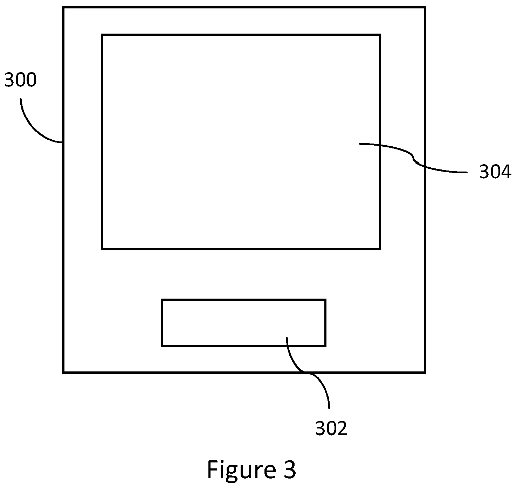

Figure 3 is a simplified schematic view of a temperature sensing device 300. The temperature sensing device 300 is for sensing aircraft wheel brake temperature (for example, the temperature of the brake 200). For example, the temperature sensing device 300 may be attached to a component of the brake in order to sense the temperature of that component of the brake 200. For example, the temperature sensing device 300 may be attached to one of the brake discs 202. In the example of Figure 2, the temperature sensing device 300 is attached to one of the stators. For example, the temperature sensing device 300 is attached to a first stator 210a, as schematically shown.

The temperature sensing device 300 may be attached to the first stator 210a in a manner that can withstand the high temperatures expected to occur at the first stator 210a. For example, the temperature sensing device 300 may be attached to the first stator 210a by means of a ceramic adhesive. Ceramic adhesive may be intended to withstand high temperatures, for example in excess of 1000°C. For example, the ceramic adhesive may be applied between the first stator 210a and the temperature sensing device 300 and cured such that the temperature sensing device 300 is bonded to the first stator 210a using cured ceramic adhesive material (for example, ceramic epoxy adhesive material). In some examples, the first stator 210a comprises a first formation (for example, one or more grooves). The first formation may be formed by cutting, grinding, drilling, or boring the first formation into the material of the first stator 210a. In such examples, a second formation may be formed from the ceramic adhesive to interlock with the first formation. For example, the ceramic adhesive with the second formation may be an attachment element for attaching the temperature sensing device 300 to the first stator 210a. For example, the second formation is complementary to the first formation. For example, the first formation is a groove formed in the first stator 210a and the second formation is a spike which fits into the groove to inhibit movement between the first stator 210a the attachment element along an axial direction and a circumferential direction of the first stator 210a. In some examples, providing the attachment element as described comprises applying uncured ceramic adhesive material to the surface of the first formation to create the second formation.

It will be appreciated that the temperature sensing device 300 may be attached to a brake disc in a number of ways. Alternatively, or in addition to the use of ceramic adhesive, other fasteners such as ceramic bolts may be used to attach the temperature sensing device 300. For example, a ceramic bolt may be passed through a through hole in the temperature sensing device 300 and engage with a threaded hole in the first stator 210a. In some examples, an appropriately shaped clip (for example, a metal clip) may be used as an attachment element. For example, the clip may comprise through holes and may be attached to the first stator 210a using bolts. Those skilled in the art will appreciate the various ways of attaching components to withstand high temperatures.

The temperature sensing device 300 comprises a surface acoustic wave (SAW) sensor element 302. In the example of Figure 3, the temperature sensing device also comprises a sensor antenna 304, which is electrically coupled to the SAW sensor element 302. The temperature sensing device 300 may be a passive device in that it does not require electrical power to operate. It will be understood that the SAW sensor element 302 works based on SAWs generated in the SAW sensor element 302. For example, the SAW sensor element 302 comprises a transducer which converts an input signal (for example, an electrical signal) into a surface acoustic wave that resonates in the SAW sensor element 302. The SAW sensor element 302 also, for example, comprises a transducer to convert the SAW into an output signal (for example, an output signal).

The temperature sensing device 300 may be configured to withstand the harsh environment of the brake discs 202. For example, the temperature sensing device may be configured to withstand at least one of: a saw tooth shock profile of 6g at 20ms duration, a saw tooth shock profile of 55g at 30ms duration, a saw tooth shock profile of 70g at 0.4ms duration, a half-sine shock profile of 40g at 30ms duration, a half-sine shock profile of 50g at 0.5ms duration, and vibration of 50g at 2 kHz for a minimum duration of 3 hours. Vibrations and/ or shock testing may be performed in accordance with Radio Technical Commission for Aeronautics (RTCA) DO-160G.

It will be understood that the SAW sensor element 302 works based on SAWs generated in the SAW sensor element 302. For example, the SAW sensor element 302 comprises a transducer which converts an input signal (for example, an electrical signal) into a surface acoustic wave that resonates in the SAW sensor element 302. The SAW sensor element 302 also, for example, comprises a transducer to convert the SAW into an output signal (for example, an output signal). Physical properties (such as temperature, for example) of the SAW sensor element may be determined based on the output signal.

The input signal may be referred to as an interrogation signal. That is because the interrogation signal causes the output signal based on which, for example, temperature can be determined. The interrogation signal therefore acts to query the SAW sensor element 302 to provide an output signal. The interrogation signal may be wirelessly received by the temperature sensing device 300. The output signal may be wirelessly transmitted by the temperature sensing device 300.

The SAW sensor element 302 comprises one or more interdigital transducers (IDTs). The IDTs are for converting between a SAW and, for example, an electrical signal. The functioning of an IDT is described further below. In some examples, the SAW sensor element 302 is a one-port SAW sensor. In such examples, the SAW sensor element 302 has one IDT. For example, the SAW sensor element 302 may have one IDT and reflectors either side of the IDT to reflect the SAW. In such examples, the one IDT converts an input signal into a SAW and also converts the SAW back into an electrical signal as a response (output) signal.

In some examples, the SAW sensor element 302 is a two-port SAW sensor. In such examples, the SAW sensor element 302 comprises two IDTs spaced apart from one another. There is an input IDT which converts an input signal into a SAW. The SAW travels from the input IDT to an output IDT. The output IDT converts the SAW into an output signal. Those skilled in the art will appreciate the various configurations of a SAW sensor element.

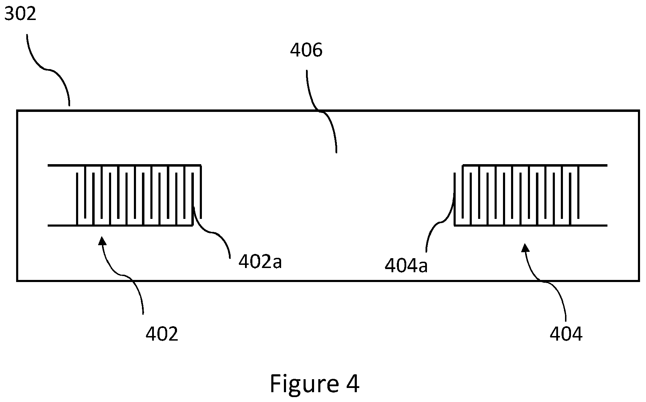

Figure 4 illustrates a particular example of the SAW sensor element 302. In this example, the SAW sensor element 302 is a two-port SAW sensor, and comprises an input IDT 402 and an output IDT 404. Each of the input IDT 420 and the output IDT 404 comprises two interlocking comb-shaped arrays of electrodes, deposited on the surface of a piezoelectric substrate 406 to form a periodic structure. The electrodes may be metallic electrodes, for example. In this example, the input IDT 402 comprises a first periodic electrode structure 402a and the output IDT 404 comprises a second periodic electrode structure 404a. The input IDT 402 is provided at a first location of the piezoelectric substrate 406 and the output IDT 404 is provided at a second location of the piezoelectric substrate 406 such that there is a space between the input IDT 402 and the output IDT 404.

Those skilled in the art will appreciate that a piezoelectric material can generate an electric charge in response to mechanical stress. Furthermore, a piezoelectric material can deform and generate mechanical stress in response to an applied electric field. An alternating electrical signal can be applied to the input IDT 402 such that adjacent electrodes have opposite polarities and the polarity of each electrode alternates according to the applied alternating electrical signal. Such a signal causes there to be a region of compressive stress next to a region of tensile stress, and each region alternates between compressive and tensile stress. As a result of this alternating compressive and tensile stress, there is generated a mechanical wave. This mechanical wave is what is referred to as a surface acoustic wave (SAW), as described above. SAWs in the SAW sensor element 302 are generated at the resonant frequency of the SAW sensor element 302.

In the example of Figure 4, the SAW travels from the input IDT 402 to the output IDT 404. The alternating regions of compressive and tensile stress caused by the SAW at the output IDT cause there to be alternating electric fields. These alternating electric fields generate an electrical signal in the output IDT such that the polarities of adjacent electrodes of the output IDT 404 alternate in the manner described above for the input IDT 402. In other words, an electrical signal is generated at the output IDT 404 by the reverse of the process which took place at the input IDT 402 to generate the SAW from the input electrical signal.

As previously described, the physical properties (such as temperature, for example) of the SAW sensor element may be determined based on the output signal. The characteristics of the SAW in the SAW sensor element 302 depend on the physical properties of the SAW sensor element such as temperature. Therefore, by detecting the characteristics of the SAW, the temperature of the SAW sensor element 302 can be determined. For example, the characteristics of the SAW are detected using the output signal generated by the output IDT 404 in response to an interrogation signal received at the input IDT 402.

Various characteristics of the SAW may be detected. For example, a delay relating to the transmission of the interrogation signal and receipt of the output signal in response from the temperature sensing device 300, a phase shift response of the SAW sensor element 302, and/or a resonant frequency of the SAW sensor element 302 may be detected. For example, the frequency of the output signal corresponds to the frequency of the SAW and therefore the resonant frequency of the SAW sensor element 302. A desired physical property of the SAW sensor element 302 (such as temperature) may then be determined from the detected characteristic of the SAW sensor element 302.

A predefined relationship between the detected characteristic (for example, the resonant frequency) of the SAW sensor element 302 and the temperature of the SAW sensor element 302 may be stored in a computer readable memory (for example, in the computing system 106) on the aircraft 100, for example. The predefined relationship specifies what the detected characteristic of the SAW sensor element 302 is expected to be at various different temperatures (for example, obtained from calibration and/or testing of the SAW sensor element 302). For example, from a given resonant frequency, the temperature of the SAW sensor element 302 is determined from the predefined relationship. The predefined relationship may be stored in the form of a look-up table, rule, correlation equation, graph, etc.

The predefined relationship may be determined by performing calibration or other tests on the SAW sensor element 302. For example, tests may be performed to cause the SAW sensor element 302 to resonate at different temperatures, and determine the resonant frequencies at those temperature, in order to establish the predefined relationship.

As previously described, the temperature sensing device 300 is attached to one of the brake discs 202. In the example of Figure 2, the temperature sensing device is attached to one of the stators 210. Therefore, the temperature of the SAW sensor element 302 corresponds to the temperature of the brake disc to which it is attached.

The interrogation signal may be wirelessly received by the temperature sensing device 300. The temperature sensing device 300 may comprise (as in the example of Figure 3) a sensor antenna 304 configured to wirelessly receive the interrogation signal, and supply the interrogation signal to the SAW sensor element 302. For example, the sensor antenna 304 receives the interrogation signal in the form of radio waves and converts the radio waves into an electrical signal. The SAW sensor element may be configured to, responsive to the interrogation signal, output a signal as a response (the described output signal), the output signal indicative of the resonant frequency of the SAW sensor element 302, to the sensor antenna 304. For example, the sensor antenna 304 may be configured to wirelessly transmit the output signal. For example, the sensor antenna 304 converts the electrical output signal into radio waves.

For example, the sensor antenna 304 supplies the interrogation signal to the input IDT 402 of the SAW sensor element 302. The interrogation signal as received at the input IDT 402 is an alternating electrical signal which causes the input IDT 402 to generate a SAW as previously described. The SAW sensor element 302 provides an output signal (generated by the output IDT 404 as previously described). For example, the output signal is supplied from the output IDT 404 to the sensor antenna 304. The sensor antenna 304 transmits the output signal. For example, the sensor antenna 304 is electrically coupled to the input IDT 402 and the output IDT 404. The origin of the interrogation signal and the components which receive and process the output signal are described later.

A change in temperature of the SAW sensor element 302 causes a change in the resonant frequency. For example, as the temperature of the SAW sensor element 302 increases, the resonant frequency of the SAW sensor element decreases. The frequency of the SAW depends on the spacing between the electrodes of the IDTs. The spacing between adjacent electrodes is referred to as the pitch of the IDT in question. The pitch determines the wavelength of the SAW generated by the IDT. The pitch is equal to half of the wavelength of the SAW generated by the IDT. Therefore, the desired frequency resonant frequency of the SAW sensor element

The frequency of the SAW depends on the propagation velocity of the SAW and the wavelength of the SAW according to Equation (1) below.

$$f = \frac{V_s}{\lambda} \tag{1}$$

In Equation (1), $f$ represents the frequency of the SAW, $V_s$ represents the propagation velocity of the SAW in the SAW sensor element in question, and $\lambda$ represents the wavelength of the SAW.

The frequency of the SAWs generated in the SAW sensor element 302 can be referred to as the resonant frequency of the SAW sensor element. It will be appreciated that, for a given propagation velocity of the SAW in the SAW sensor element 302, the resonant frequency of the SAW sensor element 302 can be configured by selecting an appropriate pitch for the IDTs of the SAW sensor element 302.

The temperature of the SAW sensor element 302 may be determined by detecting the resonant frequency of the SAW sensor element 302 as indicated by the output signal.

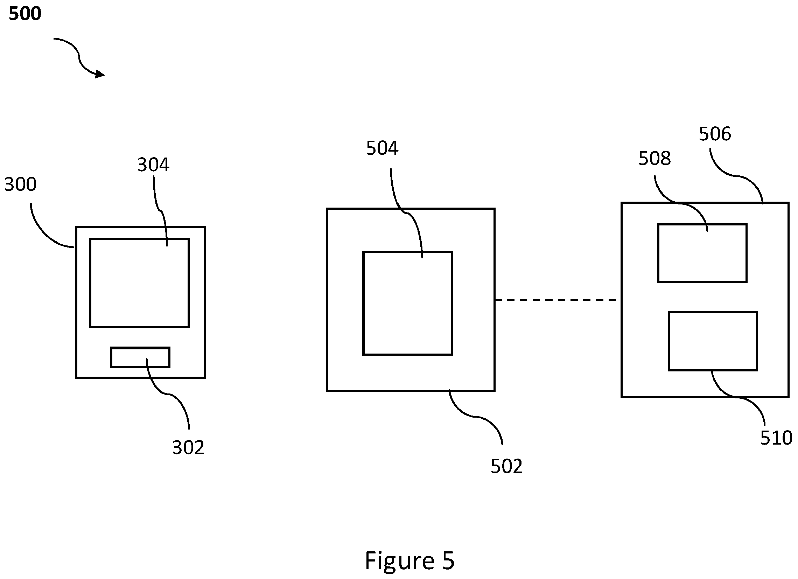

Figure 5 schematically illustrates an example of a temperature sensing system 500 for sensing aircraft wheel brake temperature. The temperature sensing system 500 comprises the temperature sensing device 300 according to any of the described examples. The temperature sensing system 500 also comprises a wireless relay device 502 for delivering the interrogation signal for wirelessly interrogating the SAW sensor element 302. The wireless relay device 502 delivers the interrogation signal by wirelessly transmitting the interrogation signal to the temperature sensing device 300. The wireless relay device 502 also wirelessly receives the described output signal. The wireless relay device 502 is hereafter simply referred to as the relay 502.

In some examples, the relay 502 comprises a relay antenna 504. The relay antenna wirelessly transmits the interrogation signal and wirelessly receives the output signal. In some such examples, the relay 502 is simply a device for communicating wirelessly with the temperature sensing device 300. As described, the temperature sensing device 300 may be attached to one of the brake discs 202. The relay 502 may be attached to a component of the brake 200 or wheel 104 such that it can wirelessly communicate with the temperature sensing device 300 attached to a brake disc. For example, the relay 502 may be mounted so as to maintain line of sight with the temperature sensing device 300.

The wireless communication between the temperature sensing device 300 and the relay 502 can be implemented, for example, by electromagnetic, inductive or capacitive coupling of the relay 502 to the temperature sensing device 300. For example, each of the sensor antenna 304 and the relay antenna 504 may be configured to convert electrical signals to radio waves and vice versa, with the radio waves being transmitted between the respective antennas.

In some examples, the temperature sensing device 300 is attached to the first stator 210a and the relay 502 is attached to the torque tube 218 to which the first stator 210a is keyed. In such examples, the relay 502 is attached to the torque tube at a position so as to be in the line of sight of the temperature sensing device 300 on the first stator 210a. In other examples, the temperature sensing device 300 may be mounted on a different brake disc or a different component of the brake 200, and the relay 502 may be mounted at an appropriate location to maintain line of sight with the temperature sensing device 300.

The temperature sensing system 500 may comprise an interrogation apparatus 506. The interrogation apparatus 506 may form part of the computing system 106 of the aircraft 100. In such examples, the interrogation apparatus 506 forms a communication link (which may be wireless or wired) with the relay 502. The interrogation apparatus 506 comprises a controller 508 configured to provide the interrogation signal. For example, the controller 508 may provide the interrogation signal based on a command signal received from another component of the computing system 106. The command signal may comprise the interrogation signal, and the interrogation signal may simply be retransmitted towards to the relay 502. In other examples, the command signal may be an instruction for the controller 508 to generate the interrogation signal.

In the example of Figure 5, the interrogation apparatus 506 comprises a transceiver 510 for transmitting the interrogation signal to the relay 502 and receiving the described output signal from the relay 502. The transceiver 510 may communicate with the relay 502 via a wired communication link or wirelessly. For example, for wireless communication, respective antennas may be provided as part of the relay 502 and the interrogation apparatus 506.

According to examples herein, the SAW sensor element 302 has a resonant frequency within a frequency range between 175 megahertz (MHz) and 190MHz at a predetermined temperature. A frequency range between 175MHz and 190MHz is not limited to a range having 175MHz as a lower limit and 190MHz as an upper limit. For example, the frequency range may be any range that falls between 175 MHz and 190 MHz (for example, 175 MHz to 180 MHz, 176 MHz to 188 MHz, 180 MHz to 190 MHz, etc.). The frequency range being a range between 175MHz and 190MHz provides for enough frequency variation such that the predetermined temperature range can include temperatures that may occur at the brake discs 202 during use of the aircraft 100. For example, the predetermined temperature may be 24°C. The frequency range may be from 176MHz to 188MHz, for example. In a particular example, the SAW sensor element 302 has a resonant frequency of 185MHz at a temperature of 24°C.

In some examples, the interrogation signal scans frequencies across the frequency range. The manner in which the interrogation signal scans frequencies (e.g. frequency step size, total time for scanning all frequencies, etc.) may be selected based on characteristics of the temperature sensing device 300, environmental characteristics in the vicinity of the temperature sensing device 300, etc.

When the frequency of the interrogation signal matches the resonant frequency of the SAW sensor element 302, the SAW sensor element 302 resonates and the output signal at the resonant frequency is generated by the output IDT 404.

Frequency ranges between 175MHz and 190 MHz do not overlap and are not close to aircraft band frequencies which are allocated to radio communication in civil aviation. Aircraft band frequencies may be between 108MHz and 137MHz. Frequency ranges between 175MHz and 190MHz (and/or the harmonics associated with such ranges) do not overlap and/or are not close to other frequencies used by other systems (for example, an Instrument Landing System and the like) on the aircraft 100. The resonant frequency of the SAW sensor element 302 is within a frequency range between 175 MHz and 190MHz at a predetermined temperature. The interrogation signal scans frequencies within this same frequency range. Accordingly, the interrogation signal and the output signal responsive to the interrogation signal do not overlap with, and are not close to, aircraft band frequencies. This means that no interference occurs between radio communication in the aircraft band and the signal received by and sent from the temperature sensing device.

Furthermore, as described, the resonant frequency of the SAW sensor element 302 depends on the pitch of the IDTs of the SAW sensor element 302. Therefore, the desired resonant frequency of the SAW sensor element 302 impacts the physical size of the SAW sensor element 302, and therefore the physical size of the temperature sensing device 300. By configuring the SAW sensor element 302 to have, at the predetermined temperature, a resonant frequency between 175 MHz and 190MHz, the temperature sensing device 300 can be made to a physical size appropriate for attachment to , for example, one of the stators included in the brake discs 202 of the brake 200.

In some examples, the resonant frequency of the SAW sensor element 302 is within the frequency range when the temperature of the SAW sensor element 302 is within a predetermined temperature range. This means that the resonant frequency remains within the frequency range for any temperature that is within the predetermined temperature range. Accordingly, the SAW sensor element 302 provides the described advantages of operating within the frequency range while being able to sense temperatures within the predetermined temperature range.

In some such examples, the resonant frequency is within the frequency range when the temperature of the SAW sensor element 302 is within the predetermined temperature range from 24°C to 1000°C. The predetermined temperature range being from 24°C to 1000°C provides that the SAW sensor element 302 can sense the temperatures likely to occur at the brake discs 202 during use of the brake 200.

Only in certain circumstances might the temperature of the brake discs approach close to 1000°C (for example, a landing requiring very hard braking, such as on a short runway). Therefore, the predetermined temperature range being from 24°C to 1000°C provides a good temperature sensing range for civil aircrafts such as the aircraft 100.

The example frequency range from 176MHz to 188MHz provides for enough variation in the resonant frequency of the SAW sensor element 302 so that the SAW sensor element 302 can detect temperature within an appropriate range for aircraft brake discs. For example, the frequency range from 176MHz to 188MHz provides for enough variation in the resonant frequency of the SAW sensor element 302 so that the SAW sensor element 302 can detect temperature within the predetermined temperature range from 24°C to 1000°C. The previously described advantages may therefore be realised while providing for temperature detection in a suitable temperature range for aircraft wheel brakes.

In some specific examples, the resonant frequency of the SAW sensor element 302 is 185MHz at 24°C, and the resonant frequency of the SAW sensor element 302 is 177MHz at 1000°C. In these examples, there is a shift in the resonant frequency of 8MHz which provides for detection of temperatures from 24°C to 1000°C.

As previously described, the temperature sensing system 500 is for sensing aircraft wheel brake temperature. The temperature sensing system 500 comprises the temperature sensing device 300 according to any of the described examples. The temperature sensing system 500 also comprises the relay 502 for delivering the interrogation signal for wirelessly interrogating the SAW sensor element 302 by wirelessly transmitting the interrogation signal to the temperature sensing device 300. For example, the interrogation signal scans frequencies within the frequency range.

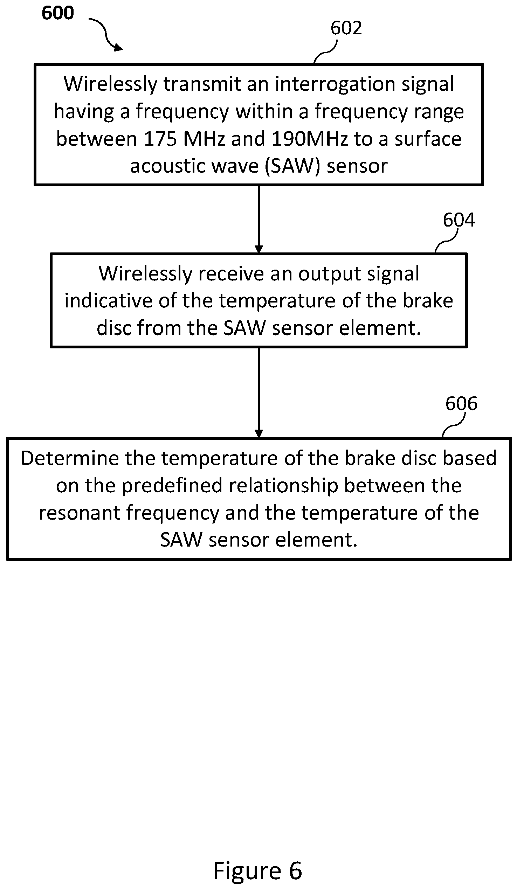

Figure 6 is a flow diagram illustrating a method 600 for sensing a temperature of a wheel brake (such as the brake 200) of an aircraft. At block 602 of the method 600, an interrogation signal (for example, the previously described interrogation signal) within a frequency range between 175MHz and 190MHz is transmitted to a surface acoustic wave sensor element (for example, the SAW sensor element 302) mounted to a brake disc of the wheel brake. For example, the SAW sensor element is mounted to the brake disc by means of being comprised in a temperature sensing device (such as the temperature sensing device 300) attached to the brake disc in question. The method 600 is hereafter described in the context of the temperature sensing device 300 being attached to the stator 210.

For example, the interrogation apparatus 506 provides the interrogation signal within a frequency range between 175MHz and 190MHz, and the interrogation signal is transmitted by the relay 502 to the temperature sensing device 300. The interrogation signal scans frequencies within the frequency range, for example, over a period of time.

For example, the relay antenna 504 transmits the interrogation signal. The sensor antenna 304 receives the interrogation signal and supplies it to the input IDT 402 in the form of an alternating electrical signal. The input IDT 402 transduces a SAW within the SAW sensor element 302.

At block 604 of the method 600, the output signal indicative of the temperature of the stator 210 is wirelessly received from the SAW sensor element.

For example, responsive to the interrogation signal arriving at the input IDT 402, the resultant SAW propagates to the output IDT 404. The output IDT 404 generates the output signal corresponding to the SAW. The output IDT 404 outputs the output signal to the sensor antenna 304. The sensor antenna 304 transmits the output signal. The output signal is wirelessly received by the relay antenna 504.

The wireless transmission of the block 602 is performed by the relay 502 and the wireless reception of block 604 is also performed by the relay 502. The relay 502 sends the output signal to the interrogation apparatus 506.

The method 600 is therefore a method of interrogating the temperature sensing device 300 attached to the stator 210 and receiving an output signal in response. It will be appreciated that the output signal is indicative of the resonant frequency of the SAW sensor element 302. At block 606 of the method 600 the temperature of the stator 210 is determined based on the predefined relationship between the resonant frequency and the temperature of the SAW sensor element 302. As previously discussed, the temperature sensing device is attached to the stator 210, for example. Therefore, the temperature dependent resonant frequency of the SAW sensor element 302 is indicative of the temperature of the stator 210.

For example, the controller 508 of the interrogation apparatus 506 processes the output signal received from the relay 502. For example, the controller 508 uses the frequency of the output signal and the predefined relationship to determine the temperature of the first stator 210. In examples where the predefined relationship is a look-up table, the controller 508 matches the frequency of the output signal to an entry in the look-up table and reads the respective temperature value for that particular entry of the look-up table as the temperature of the stator 210. In the examples of the predefined relationship being a rule, correlation equation or a graph, the controller 508 uses the frequency of the output signal as an input to determine the corresponding temperature value as the temperature of the stator 210.

As previously described, various characteristics of the SAW may be detected in order to determine the temperature of the stator 210. For example, a delay relating to the transmission of the interrogation signal and receipt of the output signal in response from the temperature sensing device 300 may be detected. Such a delay would depend on the characteristics of the SAW because the delay would vary depending on the time taken for the SAW to propagate from the input IDT 402 to the output IDT 404. The time take for this propagation depends on the propagation velocity $V_s$ of the SAW. The propagation velocity $V_s$ changes with temperature of the SAW sensor element 302.

Therefore, in some examples, the time between transmission of the interrogation signal (for example, from the transceiver 510 of the interrogation apparatus 502, or another component) and receipt of the output signal (for example, receipt by the transceiver 510, or another component) is monitored. In such examples, the predefined relationship comprises a relationship between the delay (reception time minus the transmission time) and the temperature of the SAW sensor element 302. In these examples, the controller 508 determines the temperature of the stator 210 using the delay and the predefined relationship.

In some examples, as previously described, the phase shift response of the SAW sensor element 302 may be the detected characteristic of the SAW. For example, there may be a shift in the phase of the output signal relative to the interrogation signal due to the characteristics of the SAW in the SAW sensor element 302. For example, the phase shift depends on the temperature of the SAW sensor element 302. In examples, where the phase shift is used, the predefined relationship comprises a relationship between the phase shift and the temperature of the SAW sensor element 302.

In some examples, there is provided an aircraft, such as the aircraft 100, comprising the temperature sensing system 500 according to any of the previously described examples.

Certain components are described as being electrically coupled to other components. In some examples, components may be electrically coupled by virtue of an electrical connection. Those skilled in the art will appreciate that electronic components may also be capacitively or inductively coupled, for example. The type of electrical coupling depends on the characteristics of the electronic components and the particular application.

It should be noted that the Figures show simplified schematic views for the purpose of illustration. The Figures are intended to illustrate the described concepts and are not intended to convey dimensions, relative sizes of components and the like. In some cases, certain components are not shown for simplicity, as will be appreciated by those skilled in the art.

Although the invention has been described above with reference to one or more preferred examples, it will be appreciated that various changes or modifications may be made without departing from the scope of the invention as defined in the appended claims.

**Claims**

1. A temperature sensing device for sensing aircraft wheel brake temperature, the temperature sensing device comprising:
   a surface acoustic wave, SAW, sensor element with a resonant frequency within a frequency range between 175 megahertz and 190 megahertz at a predetermined temperature.

2. The temperature sensing device according to claim 1, wherein:
   the resonant frequency is within the frequency range when the temperature of the SAW sensor element is within a predetermined temperature range.

3. The temperature sensing device according to claim 2, wherein:
   the predetermined temperature range is from 24°C to 1000°C.

4. The temperature sensing device according to any one of claims 1 to 3, wherein:
   the frequency range is from 176 megahertz to 188 megahertz.

5. The temperature sensing device according to any one of the preceding claims, comprising:

   a sensor antenna configured to wirelessly receive an interrogation signal, and supply the interrogation signal to the SAW sensor element,
   wherein:
   the interrogation signal scans frequencies within the frequency range.

6. The temperature sensing device according to claim 5, wherein:

   the SAW sensor element is configured to, responsive to the interrogation signal, output a signal as a response, the output signal indicative of the resonant frequency of the SAW sensor element, to the antenna, and
   the sensor antenna is configured to wirelessly transmit the output signal.

7. A temperature sensing system for sensing aircraft wheel brake temperature comprising the temperature sensing device according to any of claims 1 to 6, and comprising:
   a wireless relay device for delivering an interrogation signal for wirelessly interrogating the SAW sensor element by wirelessly transmitting the interrogation signal to the temperature sensing device, wherein the interrogation signal scans frequencies within the frequency range.

8. A method for sensing a temperature of a wheel brake of an aircraft, the method comprising:

   wirelessly transmitting an interrogation signal having a frequency within a frequency range between 175 megahertz and 190 megahertz to a surface acoustic wave, SAW, sensor element mounted to a brake disc of the wheel brake; and
   wirelessly receiving an output signal indicative of the temperature of the brake disc from the SAW sensor element.

9. The method according to claim 8, wherein:
   the frequency range is between 176 megahertz and 188 megahertz.

10. The method according to claim 8 or claim 9, wherein:

the interrogation signal scans frequencies within the frequency range.

11. The method according to any one of claims 8 to 10, wherein:

> the output signal is indicative of the resonant frequency of the SAW sensor element; and
> the method comprises determining the temperature of the brake disc based on a predefined relationship between the resonant frequency and the temperature of the SAW sensor element.

12. An aircraft comprising the temperature sensing system according to claim 7.

Figure 1

Figure 2

Figure 3

Figure 4

Figure 5

EP 4 187 220 A1

**600**

602

Wirelessly transmit an interrogation signal having a frequency within a frequency range between 175 MHz and 190MHz to a surface acoustic wave (SAW) sensor

604

Wirelessly receive an output signal indicative of the temperature of the brake disc from the SAW sensor element.

606

Determine the temperature of the brake disc based on the predefined relationship between the resonant frequency and the temperature of the SAW sensor element.

Figure 6

Europäisches
Patentamt

European
Patent Office

Office européen
des brevets

# EUROPEAN SEARCH REPORT

Application Number

EP 22 21 0158

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CANABAL A ET AL: "Multi-sensor wireless interrogation of SAW resonators at high temperatures", ULTRASONICS SYMPOSIUM (IUS), 2010 IEEE, IEEE, 11 October 2010 (2010-10-11), pages 265-268, XP031952924, DOI: 10.1109/ULTSYM.2010.5935789 ISBN: 978-1-4577-0382-9 | 1-6 | INV. G01K1/024 B64C25/42 F16D55/00 G01K11/26 G01K13/08 F16D66/00 |
| Y | * the whole document *  ----- | 7-12 | |
| Y | EP 3 255 399 A2 (AIRBUS OPERATIONS LTD [GB]; AIRBUS OPÉRATIONS SAS [FR]) 13 December 2017 (2017-12-13) | 7-12 | |
| A | * paragraphs [0001], [0005] - [0010], [0024], [0028], [0030] - [0039], [0041]; figure 12 *  ----- | 1-6 | |

TECHNICAL FIELDS
SEARCHED (IPC)

G01K
F16D
B64C

The present search report has been drawn up for all claims

| Place of search | Date of completion of the search | Examiner |
|---|---|---|
| The Hague | 13 March 2023 | Phleps, Stefanie |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 22 21 0158

13-03-2023

| Patent document cited in search report | | Publication date | Patent family member(s) | | Publication date |
|---|---|---|---|---|---|
| EP 3255399 | A2 | 13-12-2017 | EP | 3255399 A2 | 13-12-2017 |
| | | | EP | 3789744 A1 | 10-03-2021 |
| | | | GB | 2550364 A | 22-11-2017 |
| | | | US | 2017363482 A1 | 21-12-2017 |
| | | | US | 2020158580 A1 | 21-05-2020 |

EPO FORM P0459